# FASCICULE DE BREVET EUROPEEN

(11) **EP 0 746 110 B1**
(45) Date de publication et mention de la délivrance du brevet: **05.12.2001**
(21) Numéro de dépôt: 96401134.0
(22) Date de dépôt: 24.05.1996
(51) Int. Cl.: H03L 7/087

(54) **Procédé de verrouillage de phase et boucle appliquant ce procédé**
Verfahren zur Phasenregelung und Schleife zur Anwendung dieses Verfahrens
Method for phase locking and loop applying this method

(30) Priorité: 31.05.1995 FR 9506458
(43) Date de publication de la demande: 04.12.1996
(73) Titulaire: ALCATEL, 75008 Paris (FR)
(72) Inventeur: Bouzidi, Jean-Pierre, 22300 Lannion (FR); Ropars, Joseph, 22300 Lannion (FR)
(74) Mandataire: Sciaux, Edmond

(56) Documents cités:
- EP-A- 0 155 396
- US-A- 4 404 530
- PATENT ABSTRACTS OF JAPAN vol. 13, no. 250 (P-882), 12 Juin 1989 & JP-A-01 049176 (PIONEER ELECTRONIC CORP.), 23 Février 1989,

## Description

La présente invention concerne notamment une boucle à verrouillage de phase et elle trouve avantageusement application dans la réalisation de circuits électroniques intégrés à mode de fonctionnement numérique.

Une telle boucle peut notamment être utilisée dans un système de télécommunication pour former un signal d'horloge à partir d'un signal de type numérique porteur de données. Pour cela un premier signal d'horloge est formé à partir du signal porteur de données puis ce premier signal d'horloge est appliqué en tant que signal d'entrée à une boucle à verrouillage de phase. Cette dernière fournit en réponse un signal de sortie qui constitue un deuxième signal d'horloge présentant des qualités de forme meilleures que le premier signal d'horloge. Ce deuxième signal d'horloge permet de régénérer en phase le signal porteur de données avant de le transmettre à des circuits de réception.

Une qualité essentielle d'une telle boucle est que son signal de sortie suive aussi fidèlement que possible la fréquence et la phase de son signal d'entrée.

Les documents EP-A-0.155.396 et JP-A-1.049.176 décrivent des procédé de verrouillage de la phase d'un signal de sortie par rapport à un signal d'entrée, mettant en oeuvre un détecteur d'écart de fréquence et un détecteur d'écart de phase. En régime établi, le signal d'écart de fréquence est nul. L'oscillateur est alors commandé seulement par le signal d'écart de phase, filtré par un intégrateur. Ces procédé ont pour inconvénient qu'il subsiste un écart de phase permanent si la fréquence propre de l'oscillateur est différente de la fréquence du signal d'entrée, puisqu'il faut un écart de phase pour engendre un signal de correction.

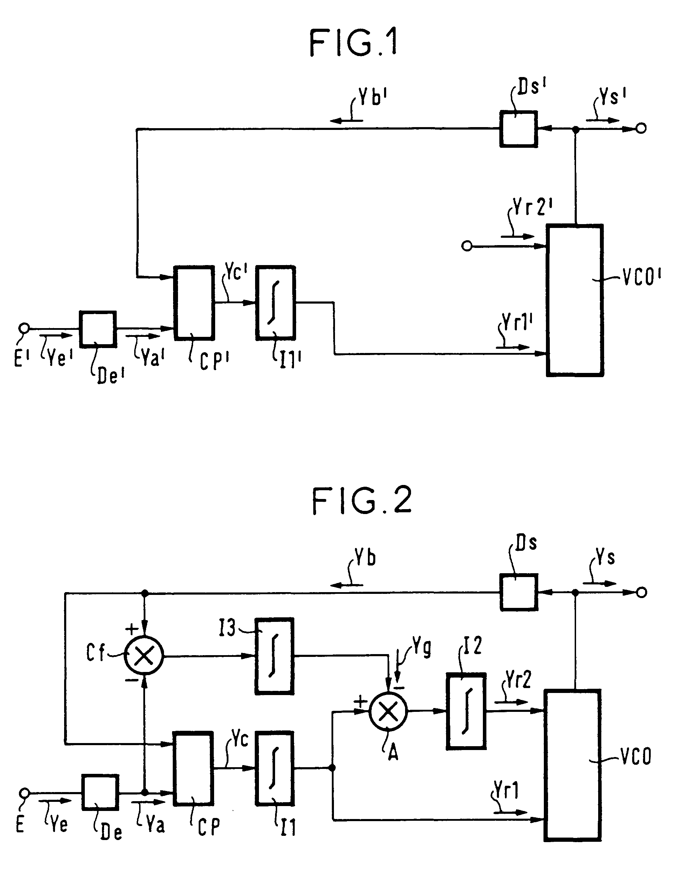

La figure 1 représente un autre type de boucle à verrouillage de phase, connu, qui comporte :
- une entrée E' pour recevoir un signal d'entrée alternatif Ye' définissant une référence de phase,
- un comparateur de phase CP' sensible d'une part à cette référence de phase d'autre part à la phase d'un signal de sortie alternatif Ys' présentant une fréquence de sortie, ce comparateur fournissant un signal d'écart de phase représentatif d'un écart de phase présenté par le signal de sortie par rapport à la référence de phase,
- un intégrateur d'écart de phase I1' recevant et intégrant ce signal d'écart de phase pour fournir un signal de correction de fréquence Yr1',
- et un oscillateur de boucle VC0' présentant une fréquence propre et recevant le signal de correction de fréquence. Cet oscillateur fournit le signal de sortie en introduisant, entre la fréquence de sortie commandée par le signal de correction de fréquence et sa fréquence propre, une différence présentant un sens propre à diminuer l'écart de phase.

Il doit être compris que, comme bien connu, les intégrateurs utilisés dans ce domaine technique présentent un gain limité à fréquence nulle, c'est-à-dire qu'ils ne réalisent pas une intégration au sens mathématique du terme, mais plutôt un filtrage éliminant les fréquences hautes.

Le comparateur de phase est par exemple d'un type décrit dans le livre "Technique des boucles d'asservissement de phase" par Alain Blanchard édité par l'Ecole Supérieure d'Electricité (Paris) (Chapitre 2) ou dans le livre "Phase locked loops" par Roland E. Best, édité par Mc Graw Hill (Chapitre 4).

Dans un cas typique il ne peut pas fonctionner à la fréquence commune au signal d'entrée Ye et au signal de sortie Ys, par exemple 155 MHz. C'est pourquoi cette fréquence est divisée, avant comparaison de phase, par un diviseur D'ₑ ou D'ₛ qui la divise par un nombre entier,

Une telle boucle permet de caler exactement la phase du signal de sortie sur la référence de phase à condition notamment que la fréquence propre de l'oscillateur de boucle soit égale à la fréquence d'entrée. Or même dans le cas où la fréquence d'entrée est une fréquence fixe prédéterminée cette condition est difficile à remplir dans un cadre industriel.

En effet, des oscillateurs fabriqués dans un tel cadre présentent nécessairement une certaine dispersion de leurs caractéristiques, c'est-à-dire notamment de leurs fréquences propres. De plus ces caractéristiques peuvent varier avec le temps. Il en résulte que la fréquence propre de l'oscillateur est généralement différente de la fréquence d'entrée et donc de la fréquence de sortie.

Cet écart de fréquence doit être compensé par un signal de correction non nul, c'est-à-dire qu'un écart de phase résiduel apparaît même en régime établi. Cet écart de phase est d'autant plus grand que l'écart de fréquence est grand.

Dans le but de diminuer cet écart de phase résiduel, il est connu d'appliquer à l'oscillateur de boucle un deuxième signal de correction de fréquence Yr'2 qui s'ajoute au premier et dont la valeur est fixée lors de la fabrication de la boucle pour compenser l'écart constaté entre la fréquence propre de l'oscillateur et une fréquence d'entrée prédéterminée.

L'écart de phase résiduel est ainsi diminué mais il subsiste, notamment quand la fréquence propre de l'oscillateur varie au cours du temps ou quand la fréquence d'entrée varie.

La présente invention a notamment pour buts de diminuer encore cet écart de phase résiduel et de faciliter l'adaptation de la boucle à une variation de la fréquence d'entrée.

Dans ces buts elle a notamment pour objet un procédé de verrouillage de la phase d'un signal de sortie par rapport à un signal d'entrée, procédé dans lequel un premier signal de correction de fréquence est obtenu par intégration d'un signal représentatif d'un écart de ladite phase par rapport à une référence de phase définie par le signal d'entrée puis ce premier signal de correction de fréquences coopère avec un deuxième signal de correction de fréquence pour corriger la fréquence d'un oscillateur fournissant ledit signal de sortie, ce procédé étant caractérisé par le fait que le deuxième signal de correction de fréquence est obtenu avec l'aide d'un signal de réglage par intégration d'un écart du premier signal de correction de fréquence par rapport à ce signal de réglage.

La figure 1 représente une boucle à verrouillage de phase connue et a déjà été décrite.

La figure 2 représente une boucle à verrouillage de phase selon la présente invention.

Conformément à la figure 2 cette dernière boucle comporte, comme connu en soi, une entrée E recevant un signal d'entrée alternatif et plus particulièrement binaire Ye. La fréquence de ce signal peut être entachée de fluctuations autour d'une valeur moyenne constituant une fréquence d'entrée fe. Cette valeur moyenne peut elle-même subir une évolution au cours du temps. Ce signal définit une référence de phase.

Un comparateur de phase CP recoit d'une part le signal d'entrée à travers un diviseur de fréquence De d'autre part un signal de sortie alternatif Ys à travers un diviseur de fréquence Ds. Les nombres diviseurs de ces diviseurs de fréquence sont choisis pour ramener deux fréquences égales sur le comparateur de phase CP. Le signal de sortie λs présente une fréquence de sortie fs et un écart de phase θs par rapport à la référence de phase. Le comparateur CP fournit un signal d'écart de phase Yc représentatif de cet écart de phase. Un intégrateur d'écart de phase I1 reçoit et intégre ce signal d'écart de phase pour fournir un signal de correction de fréquence Yr1 ayant la forme d'une tension. Des moyens de compensation d'écart de fréquence qui seront décrits plus loin fournissent un deuxième signal de correction de fréquence Yr2 ayant lui aussi la forme d'une tension. Enfin un oscillateur de boucle VC0 présentant une fréquence propre fo reçoit les premier et deuxième signaux de correction de fréquence et fournit le signal de sortie Ys. Il introduit entre la fréquence de sortie fs et sa fréquence propre une différence croissant avec les premier et deuxième signaux de correction de fréquence et présentant un sens propre à diminuer ledit écart de phase.
Selon la présente invention les moyens de compensation d'écart de fréquence comportent :
- des moyens de réglage pour fournir un signal de réglage Yg,
- un additionneur A recevant d'une part le premier signal de correction de fréquence, d'autre part le signal de réglage et soustrayant ce signal de réglage du premier signal de correction de fréquence pour fournir un signal d'écart de compensation,
- et un intégrateur de compensation I2 recevant et intégrant le signal d'écart de compensation pour fournir le deuxième signal de correction de fréquence.

De préférence, et comme représenté, lesdits moyens de réglage comportent un comparateur de fréquence Cf recevant d'une part le signal d'entrée Ye d'autre part le signal de sortie Ys. Ce comparateur fournit en réponse un signal d'écart de fréquence représentatif d'un écart de fréquence présenté par la fréquence de sortie par rapport à la fréquence d'entrée. Ce signal d'écart de fréquence peut par exemple présenter une valeur nulle lorsque l'écart de fréquence reste dans certaines limites, c'est-à-dire reste inférieur en valeur absolue à un seuil prédéterminé dépendant du choix des éléments CP, I1 et VC0. Dans cet exemple il peut présenter une valeur - 1 ou une valeur + 1 lorsque l'écart de fréquence sort de ces limites respectivement dans un sens ou dans l'autre. Un intégrateur d'écart de fréquence I3 reçoit et intégre ce signal d'écart de fréquence pour fournir le signal de réglage Yg en faisant varier ce dernier signal dans un sens propre à diminuer ledit écart de fréquence.
Cette structure des moyens de réglage permet, lors du démarrage de la boucle, de compenser d'éventuels écarts entre la fréquence d'entrée et la fréquence propre de l'oscillateur. Au contraire, si le signal de réglage était constant, de tels écarts pourraient empêcher le verrouillage de l'oscillateur de boucle par rapport au signal d'entrée.

## Revendications

1. Procédé de verrouillage de la phase d'un signal de sortie (Ys) par rapport à un signal d'entrée (Ye), procédé dans lequel un premier signal de correction de fréquence (Yr1) est obtenu par intégration d'un signal représentatif d'un écart de ladite phase par rapport à une référence de phase définie par le signal d'entrée puis ce premier signal de correction de fréquence coopère avec un deuxième signal de correction de fréquence (Yr2) pour corriger la fréquence d'un oscillateur (VCO) fournissant ledit signal de sortie, ce procédé étant **caractérisé par le fait que** le deuxième signal de correction de fréquence (Yr2) est obtenu avec l'aide d'un signal de réglage (Yg) par intégration d'un écart du premier signal de correction de fréquence (Yr1) par rapport à ce signal de réglage.

2. Boucle à verrouillage de phase comportant :
- une entrée (E) pour recevoir un signal d'entrée alternatif (Ye) présentant une fréquence d'entrée (fe) et définissant une référence de phase,
- un comparateur de phase (CP) sensible d'une part à cette référence de phase d'autre part à la phase d'un signal de sortie alternatif Ys présentant une fréquence de sortie (fs), ce comparateur fournissant un signal d'écart de phase (Yc) représentatif d'un écart de phase (θs) présenté par le signal de sortie par rapport à la référence de phase,
- un intégrateur d'écart de phase (I1) recevant et intégrant ce signal d'écart de phase pour fournir un premier signal de correction de fréquence (Yr1),
- des moyens de compensation d'écart de fréquence fournissant un deuxième signal de correction de fréquence (Yr2),
- et un oscillateur de boucle (VC0) présentant une fréquence propre (fo) et recevant les premier et deuxième signaux de correction de fréquence, cet oscillateur fournissant ledit signal de sortie (Ys) et introduisant entre ladite fréquence de sortie (fs) et sa dite fréquence propre une différence croissant avec lesdits premier et deuxième signaux de correction de fréquence et présentant un sens propre à diminuer ledit écart de phase, cette boucle étant **caractérisée par le fait que** lesdits moyens de compensation d'écart de fréquence comportent :
- des moyens de réglage pour fournir un signal de réglage (Yg),
- un additionneur (A) recevant d'une part ledit premier signal de correction de fréquence, d'autre part par ledit signal de réglage et soustrayant ce signal de réglage du premier signal de correction pour fournir un signal d'écart de compensation,
- et un intégrateur de compensation (I2) recevant et intégrant le signal d'écart de compensation pour fournir le deuxième signal de correction de fréquence.

3. Boucle selon la revendication 2 **caractérisé par le fait que** lesdits moyens de réglage comportent :
- un comparateur de fréquence (Cf) sensible d'une part à ladite fréquence d'entrée (fe) d'autre part à ladite fréquence de sortie (fs) et fournissant en réponse un signal d'écart de fréquence représentatif d'un écart de fréquence présenté par cette fréquence de sortie par rapport à cette fréquence d'entrée,
- et un intégrateur d'écart de fréquence (I3) recevant et intégrant ce signal d'écart de fréquence pour fournir ledit signal de réglage (Yg) en faisant varier ce dernier signal dans un sens propre à diminuer ledit écart de fréquence.

## Patentansprüche

1. Verfahren zur Phasenregelung eines Ausgangssignals (Ys) in Bezug auf ein Eingangssignal (Ye), bei dem erstes Frequenzkorrektursignal (Yr1) durch Integration eines Signals erhalten wird, das für eine Abweichung der Phase von einer durch das Eingangssignal definierten Phasenreferenz repräsentativ ist, dann dieses erste Frequenzkorrektursignal mit einem zweiten Frequenzkorrektursignal (Yr2) zusammenwirkt, um die Frequenz eines Oszillators (VCO) zu korrigieren, der das Ausgangssignal liefert, **dadurch gekennzeichnet, dass** das zweite Frequenzkorrektursignal (Yr2) mit Hilfe eines Regelungssignals (Yg) durch Integration einer Abweichung des ersten Frequenzkorrektursignals (Yr1) von diesem Regelungssignal erhalten wird.

2. Phasenregelschleife mit:
- einem Eingang (E) zum Empfangen eines alternierenden Eingangssignals (Ye), das eine Eingangsfrequenz (fe) aufweist und eine Phasenreferenz definiert,
- einem Phasenkomparator (CP), der einerseits auf diese Phasenreferenz und andererseits auf die Phase eines alternierenden Ausgangssignals (Ys) empfindlich ist, das eine Ausgangsfrequenz (fs) aufweist, wobei dieser Komparator ein Phasenabweichungssignal (Yc) liefert, das für eine Phasenabweichung (θs) des Ausgangssignals von der Phasenreferenz repräsentativ ist,
- einem Integrator für die Phasenabweichung (I1), der dieses Phasenabweichungssignal empfängt und integriert, um ein erstes Frequenzkorrektursignal (Yr1) zu liefern,
- Frequenzabweichungskompensationsmitteln, die ein zweites Frequenzkorrektursignal (Yr2) liefern,
- und einem Schleifenoszillator (VCO), der eine Eigenfrequenz (fo) aufweist und das erste und das zweite Frequenzkorrektursignal empfängt, wobei dieser Oszillator das Ausgangssignal (Ys) liefert, und zwischen dieser Ausgangsfrequenz (fs) und seiner Eigenfrequenz eine Differenz einführt, die mit dem ersten und dem zweiten Frequenzkorrektursignal zunimmt und eine geeignete Richtung aufweist, um die Phasenabweichung zu verringern,
**dadurch gekennzeichnet, dass** die
Frequenzabweichungskompensationsmittel umfassen:
- Regelungsmittel zum Liefern eines Regelungssignals (Yg),
- einen Addierer (A), der einerseits das erste Frequenzkorrektursignal und andererseits das Regelungssignal empfängt und dieses Regelungssignal von dem erscen Korrektursignal subtrahiert, um ein Kompensations-Abweichungssignal zu liefern,
- und einen Kompensationsintegrator (I2), der das Kompensations-Abweichungssignal empfängt und integriert, um das zweite Frequenzkorrektursignal zu liefern.

3. Schleife nach Anspruch 2, **dadurch gekennzeichnet, dass** die Regelungsmittel umfassen:
- einen Frequenzkomparator (Cf), der einerseits auf die Eingangsfrequenz (fe) und andererseits auf die Ausgangsfreauenz (fs) empfindlich ist und in Reaktion ein Frequenzabweichungssignal liefert, das für eine Frequenzabweichung dieser Ausgangsfrequenz von der Eingangsfrequenz repräsentativ ist,
- und einen Frequenzabweichungsintegrator (I3), der dieses Frequenzabweichungssignal empfängt und integriert, um das Regelungssignal (Yg) zu liefern, indem er dieses letztere Signal in einer zum Verringern der Frequenzabweichung geeigneten Richtung variiert.

## Claims

1. A method of phase-locking an output signal (Ys) relative to an input signal (Ye), in which method a first frequency correction signal (Yr1) is obtained by integrating a signal representative of an error in said phase relative to a reference phase defined by an input signal, and then said first frequency correction signal co-operates with a second frequency correction signal (Yr2) for correcting the frequency of an oscillator (VCO) supplying said output signal,
said method being **characterized by** the fact that the second frequency correction signal (Yr2) is obtained with the help of an adjustment signal (Yg) by integrating an error of the first frequency correction signal (Yr1) relative to said adjustment signal.

2. A phase-locked loop comprising:
· an input (E) for receiving an alternating input signal (Ye) having an input frequency (fe) and defining a reference phase;
· a phase comparator (CP) responsive firstly to said reference phase and secondly to the phase of an alternating output signal (Ys) having an output frequency (fs), said comparator supplying a phase error signal (Yc) representative of a phase error (θs) presented by the output signal relative to the reference phase;
· a phase error integrator (I1) receiving and integrating said phase error signal to provide a first frequency correction signal (Yr1);
· frequency error compensation means providing a second frequency correction signal (Yr2); and
· a loop oscillator (VCO) having a natural frequency (f0) and receiving the first and second frequency correction signals, said oscillator supplying said output signal (Ys) and inserting between its said natural frequency and said output frequency (fs) a difference that increases with said first and second frequency correction signals and that presents a direction suitable for reducing said phase error;
said loop being **characterized by** the fact that said frequency error compensation means comprise:
˙ adjustment means for supplying an adjustment signal (Yg);
˙ an adder (A) receiving both said first frequency correction signal and said adjustment signal, and subtracting said adjustment signal from the first correction signal to supply a compensation error signal; and
˙ a compensation integrator (I2) receiving and integrating the compensation error signal to supply the second frequency correction signal.

3. A loop according to claim 2, **characterized by** the fact that said adjustment means comprise:
˙ a frequency comparator (Cf) responsive firstly to said input frequency (fe) and secondly to said output frequency (fs) and supplying in response thereto a frequency error signal representative of a frequency error presented by said output frequency relative to said input frequency; and
˙ a frequency error integrator (I3) receiving and integrating said frequency error signal to supply said adjustment signal (Yg) by making said adjustment signal vary in a direction that is suitable for reducing said frequency error.
